Europäisches Patentamt

European Patent Office

Office européen des brevets

(11) Publication number: **0 225 698**
**B1**

(19)

(12) **EUROPEAN PATENT SPECIFICATION**

(45) Date of publication of the patent specification:
01.08.90

(21) Application number: 86307871.3

(22) Date of filing: 10.10.86

(51) Int. Cl.⁵: **G11C 11/34,** G11C 11/56,
H03K 3/36, H03K 23/00,
H03K 29/00

(54) Logic circuitry.

(30) Priority: 12.10.85 JP 226004/85
14.06.86 JP 138630/86
14.06.86 JP 138631/86

(43) Date of publication of application:
16.06.87 Bulletin 87/25

(45) Publication of the grant of the patent:
01.08.90 Bulletin 90/31

(84) Designated Contracting States:
DE FR GB

(56) References cited:
JAPANESE JOURNAL OF APPLIED PHYSICS, vol. 24,
no. 11, November 1985, pages L853-L854; N.
YOKOYAMA et al.: "A new functional,
resonant-tunneling hot electron transistor (RHET)"
IEEE JOURNAL OF SOLID-STATE CIRCUITS, vol. SC-16,
no. 2, April 1981, pages 80-85, New York, US; M.I.
ELMASRY et al.: "SDW MOSFET static memory cell"

(73) Proprietor: FUJITSU LIMITED, 1015, Kamikodanaka
Nakahara-ku, Kawasaki-shi Kanagawa 211(JP)

(72) Inventor: Yokoyama, Naoki, Riba-haitsu 326 2557-1,
Tsumada, Atsugi-shi Kanagawa 243(JP)
Inventor: Mori, Toshihiko, Fujitsu Atsugi-ryo 2-3-10,
Sakae-cho, Atsugi-shi Kanagawa 243(JP)

(74) Representative: Fane, Christopher Robin King et al,
HASELTINE LAKE & CO. Hazlitt House 28 Southampton
Buildings Chancery Lane, London, WC2A 1AT(GB)

## Description

The present invention relates to logic circuitry.

Latch circuits, memory cells and frequency dividers using bipolar transistors and/or metal insulation semiconductor (MIS) transistors have been used extensively for many years. In the prior art, however, a practical static memory cell requires at least two conventional transistors, and a practical frequency divider requires at least three conventional transistors. As a result, the prior art memory cell and the frequency divider suffer from the disadvantages of a complex circuit arrangement, and accordingly, a low integration density. These circuits also suffer from a disadvantage of a low operation speed.

Memory cells using diodes having a differential negative-resistance characteristic are also known in the prior art. These memory cells feature a simple circuit arrangement but have a poor operation stability.

Although a higher potentiality of a three terminal resonant-tunneling device has long been recognized, it could not be realized in practice due to the difficulties involved in the relevant semiconductor processing technology. More recently, however, due to advances in aspects of this semiconductor processing technology, such as molecular beam epitaxy (MBE) and metal organic chemical vapor deposition (MOCVD), practical resonant-tunneling transistors have been developed (e.g., "RESONANT-TUNNELING HOT ELECTRON TRANSISTORS (RHET): POTENTIAL AND APPLICATIONS", N. Yokoyama, et al, Japanese Journal of Applied Physics, Vol. 24, No. 11, November 1985, pp. L853 - L854).

An embodiment of the present invention can provide a latch circuit having a comparatively simple circuit arrangement, a relatively reduced circuit size, and a relatively stable and high speed operation, by using a resonant-tunneling transistor e.g. a resonant-tunneling hot electron transistor (RHET) or a resonant-tunneling bipolar transistor (RBT).

In addition, an embodiment of the present invention can provide a memory cell having a relatively simple circuit arrangement, a comparatively reduced circuit size, and a relatively stable and high speed operation, also by using a resonant-tunneling transistor.

Further, an embodiment of the present invention can provide a frequency dividing circuit having a comparatively stable and high speed operation, a relatively simple circuit arrangement, and a relatively reduced circuit size, by using at least one resonant-tunneling transistor.

Still further, an embodiment of the present invention can provide a latch circuit and a memory cell having multilevel stable states.

According to one aspect of the present invention, there is provided a logic circuit including: a resonant-tunneling transistor including a superlattice containing at least one quantum well layer; and a constant current source operatively connected between a base and an emitter of the transistor and supplying a constant current to the base. The transistor has a differential negative-resistance characteristic with at least one resonant point in a relationship between a current flowing into the base and a voltage between the base and emitter, and having at least two stable base current values at both sides of the resonant point on the characteristic, defined by the changeable base • emitter voltage.

The resonant-tunneling transistor may be a resonant-tunneling hot electron transistor (RHET) or a resonant-tunneling bipolar transistor (RBT).

The logic circuit may further include a load unit operatively connected to a collector of the transistor, and an output circuit connected to a common connection point of the load unit and the collector for outputting a voltage defined by the change of a current flowing through the collector, which voltage is varied in response to the two stable base current values.

According to another aspect of the present invention, there is provided a logic circuit including the above transistor; the above constant current source; and a write unit operatively connected to a collector of the transistor and changing a voltage at the collector.

The write unit changes the collector voltage to change a current flowing through the collector, and the base•emitter voltage is changed in response to the change of the collector voltage, so that the transistor holds one of at least two stable states defined by the stable base current values in response to the change of collector voltage.

According to yet another aspect of the present invention, there is provided a semiconductor memory device including a plurality of memory cells arranged between a plurality of bit lines and a plurality of word lines in a matrix. Each memory cell includes the above latch circuit for latching data and a switching element operatively connected between a commonly connected point of the collector and the resistor in the current supply source and a corresponding bit line and having a control terminal operatively connected to a corresponding word line. The transistor holds one of at least two stable states in response to the change of a voltage at the collector supplied through the switching element in a combination of voltages on the bit line and the word line, and the transistor outputs one of at least two voltages corresponding to the held stable states to the bit line through the switching element energized by a voltage on the word line.

According to a further aspect of the present invention, there is also provided a latch circuit including the above transistor; the above constant current source; and a write unit operatively connected to the base and supplying a write voltage to the base.

The write unit supplies one of at least two write voltages corresponding to the stable base current values to the base to change the base•emitter voltage so that the transistor holds one stable state defined by the changed base•emitter voltage, and the latch circuit outputs at the collector a current changeable in response to the state held in the transistor.

The latch circuit may further include a circuit connected to the collector and supplying a current to the collector through a resistor therein. The latch circuit outputs a voltage at the collector in response to the state held in the transistor. The write unit may include a switching element having a terminal operatively connected to the base and another terminal receiving a data signal and a control terminal receiving a control signal energizing same. The switching element outputs a data signal having one amplitude of at least two amplitudes corresponding to the stable base current values to the base in response to the control signal to change the base • emitter voltage, so that the transistor holds one stable state defined by the changed base • emitter voltage.

An input signal having a predetermined frequency and an amplitude of at least two amplitudes corresponding to the stable base current values is supplied to the clock input terminal, so that an output signal that is a half of the input frequency is output from the collector.

The signal input circuit may include a switching element having a terminal operatively connected to the base and another terminal as the data input terminal and a control terminal as the clock input terminal.

According to another aspect of the present invention, there is provided a dynamic frequency divider including: the above transistor; the above constant current source; the above collector current supplying unit; and a signal input circuit operatively connected to the base and having a data input terminal and a clock input terminal. The data input terminal and the collector are connected.

According to yet another aspect of the present invention, there is provided a static frequency divider including: a first delay-type flip-flop (D–FF) having a clock input terminal receiving an input signal; a second D–FF having a data input terminal operatively connected to an positive output terminal of the first D–FF; a first inverter provided between the clock input terminal of the first D–FF and a clock input terminal of the second FF; and a second inverter operatively connecting a positive output terminal of the second FF and a data input terminal of the first D–FF, each D–FF including the latch circuit of the above dynamic frequency divider.

Reference will now be made, by way of example, to the accompanying drawings, in which:

Fig. 1 is a circuit diagram of a semiconductor memory of the prior art;
Fig. 2a shows a sectional view of a semifinished resonant-tunneling hot electron transistor (RHET) for use in an embodiment of the present invention;
Fig. 2b is a graph of an energy band of the RHET shown in Fig. 2a;
Fig. 2c is a view representing an energy-band of a resonant-tunneling bipolar transistor (RBT);
Figs. 3a to 3c are graphs of energy levels of the RHET shown in Fig. 2a;
Fig. 4 is a graph of the characteristic of the RHET shown in Fig. 2a;
Fig. 5 is a circuit diagram of a semiconductor memory cell embodying the present invention;

Fig. 6 is a graph representing the characteristic of the memory cell shown in Fig. 5;
Figs. 7a and 7b are graphs of energy levels of the RHET in the memory cell shown in Fig. 5;
Figs. 8a to 8c are timing charts of the memory cell shown in Fig. 5;
Figs. 9a and 9b are graphs representing energy levels of the RHET in the memory cell shown in Fig. 5;
Fig. 10 is a circuit diagram of a delay-type flip-flop (D–FF) embodying the present invention;
Fig. 11 is a block diagram representing the circuit shown in Fig. 10;
Figs. 12a to 12d are graphs representing energy levels of the RHET in the flip-flop shown in Fig. 10;
Fig. 13 is a graph representing the basic characteristic of the flip-flop shown in Fig. 10;
Figs. 14a and 14b are graphs representing the operating characteristic of the flip-flop shown in Fig. 10;
Fig. 15 is a graph illustrating the operation of the flip-flop shown in Fig. 10;
Fig. 16 is a block diagram of a dynamic frequency divider using the D–FF shown in Fig. 10;
Fig. 17 is a block diagram of a static frequency divider using the D–FF shown in Fig. 10; and
Figs. 18a to 18e are timing charts of the operation of the static frequency divider shown in Fig. 17.

Before describing the preferred embodiments of the present invention, a description will be given of the prior art.

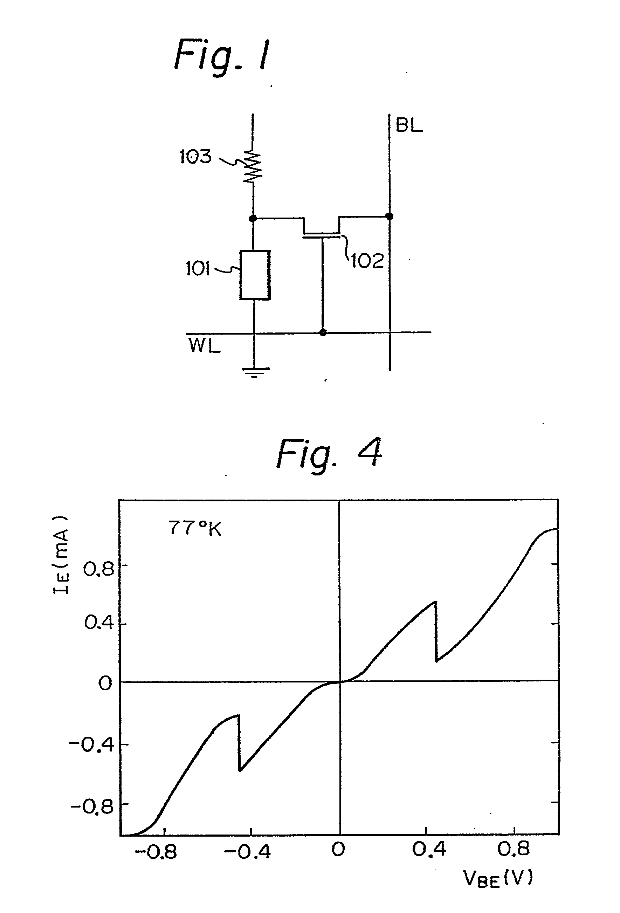

Figure 1 is a circuit diagram of a semiconductor memory of the prior art using a diode having a negative-resistance characteristic. The semiconductor memory includes a diode 101 having a negative-resistance characteristic, a load resistor 103 connected to the diode 101, and a transfer gate 102 having a gate connected to a word line WL and a source connected to a bit line BL. The semiconductor memory carries out the read and write operations by using the negative resistance feature of the diode, and thus functions as a memory but does not provide a stable information storage. This is because the read and write operations are effected by using the same circuit. Namely, in the read operation, a current is extracted from the diode 101 through the transfer gate 102 and a current for restoring the content is again given to the diode 101 through the transfer gate 102.

Also before describing the preferred embodiments of the present invention, a description will be given of a principle of a RHET for use in an embodiment of the present invention.

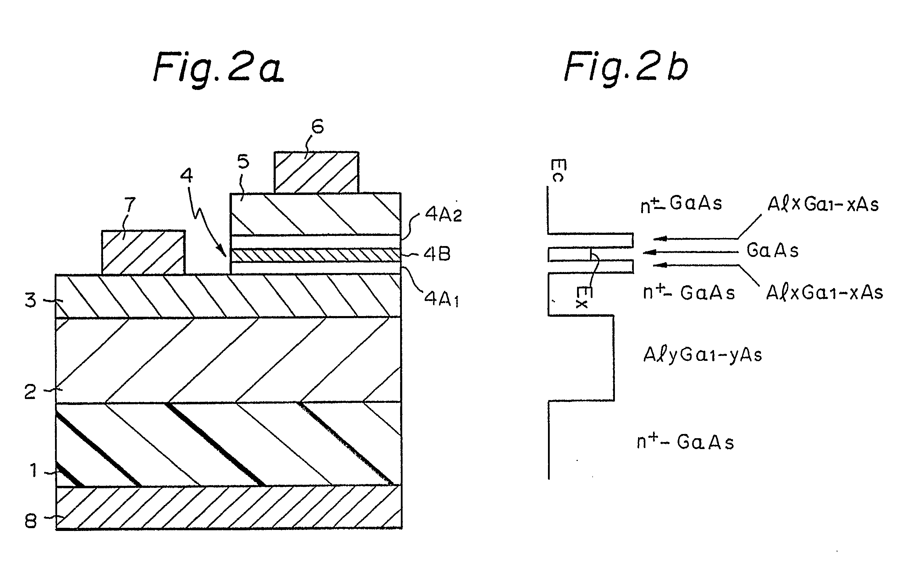

Figure 2a is a sectional view of a semifinished RHET, and Fig. 2b is a graph of an energy band of the RHET shown in Fig. 2a. In Fig. 2a, the RHET consists of a collector electrode 8, an $n^+$-type GaAs collector layer 1 formed on the collector electrode 8, a non-doped impurity $Al_yGa_{1-y}As$ (e.g. y = 0.3) collector side potential barrier layer 2 formed on the collector layer 1, an $n^+$-type GaAs base layer 3 formed on the potential barrier layer 2, a superlattice layer 4, an $n^+$-type GaAs emitter layer 5, an emitter electrode 6, and a base electrode 7. The superlattice layer 4 consists of an $Al_xGa_{1-x}As$ barrier layer $4A_1$, a non-doped impurity GaAs quantum well layer 4B, and an $Al_xGa_{1-x}As$ barrier layer $4A_2$, and functions as an emitter-side potential barrier. In this specification, although the superlattice is shown as having at least one quantum well provided therein, plurality of quantum wells may be provided if desired.

In Fig. 2b, reference $E_C$ represents a base of a conduction energy band, $E_F$ a Fermi level, and $E_X$ an energy level of a sub-band at the quantum well layer 4B.

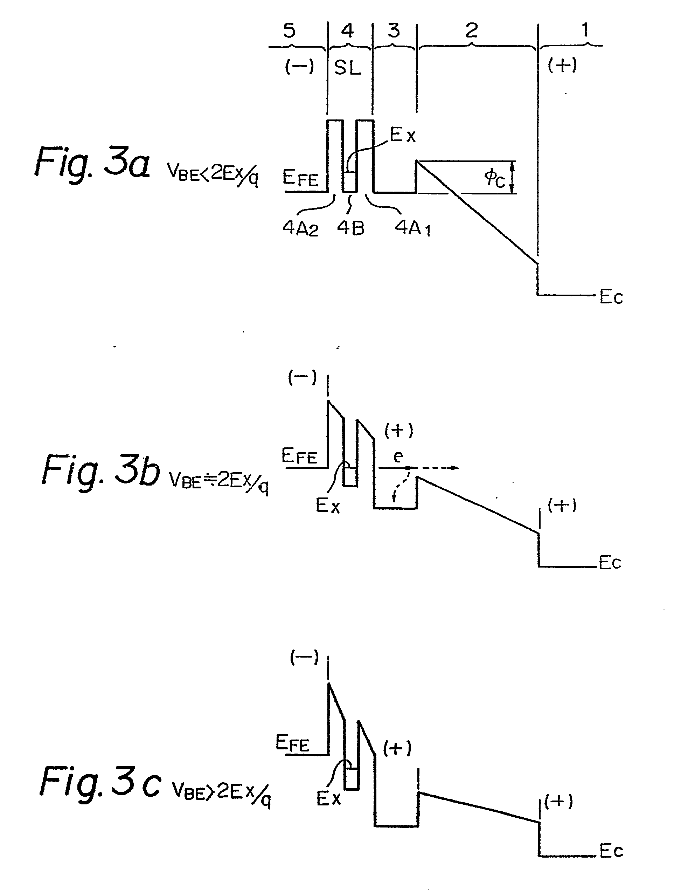

The principle of the operation of the RHET will now be described with reference to Figs. 3a to 3c. In the Figures, reference $E_{FE}$ represents a pseudo-Fermi level, and $\varnothing_c$ a conduction-band discontinuity. Note, the numerals 1 to 5, running from left to right at the top of the figures, represent the corresponding layers in the device shown in Fig. 2a.

Figure 3a is a graph of an energy band of the RHET when a voltage $V_{BE}$ between the base layer 3 and the emitter layer 5 is lower then $2 \cdot E_X/q$; wherein $q$ represents the carrier charges, or is too low, for example, approximately zero volt. In Fig. 3a, although a voltage $V_{CE}$ exists between the collector layer 1 and the emitter layer 5, electrons at the emitter layer 5 cannot reach the base layer 3 by tunneling through the superlattice 4, since the base • emitter voltage $V_{BE}$ is almost zero and thus the level of an energy $E_{FE}$ of the emitter layer 5 differs from the sub-band energy level $E_X$. Accordingly, a current does not flow between the emitter layer 5 and the collector layer 1.

Figure 3b is a graph of an energy band of the RHET when the base • emitter voltage $V_{BE}$ is approximately equal to $2 \cdot E_X/q$. Here, the energy level $E_{FE}$ at the emitter layer 5 is substantially equal to the sub-band energy level $E_X$ at the quantum well layer 4B, and because of a resonant-tunneling effect, electrons at the emitter layer 5 are passed through the superlattice layer 4 and injected in the base layer 3. The potential energy of the injected electrons of aproximately $2 \cdot E_X$, for example, 0.3 eV, is converted to a kinetic energy, bringing the electrons to a so-called "hot" state. The hot electrons are ballistically passed through the base layer 3 and reach the collector layer 1 if the kinetic energy is higher than the collector barrier level, and as a result, a current flows between the emitter layer 5 and the collector layer 1. And, if the kinetic energy is lower than the collector barrier level, the electrons cannot reach the collector layer, but they contribute to flow a base current.

Figure 3c is a graph of an energy band of the RHET when the base • emitter voltage $V_{BE}$ is higher than $2 \cdot E_X/q$. The energy level $E_{FE}$ at the emitter layer 5 is higher than the sub-band energy level $E_X$ at the quantum well layer 4B. Therefore, the resonant-tunneling effect does not occur, and the electrons from the emitter layer 5 cannot be introduced into the base layer 3. Consequently, the current flowing into the RHET is reduced so that a collector current and/or a base current are decreased.

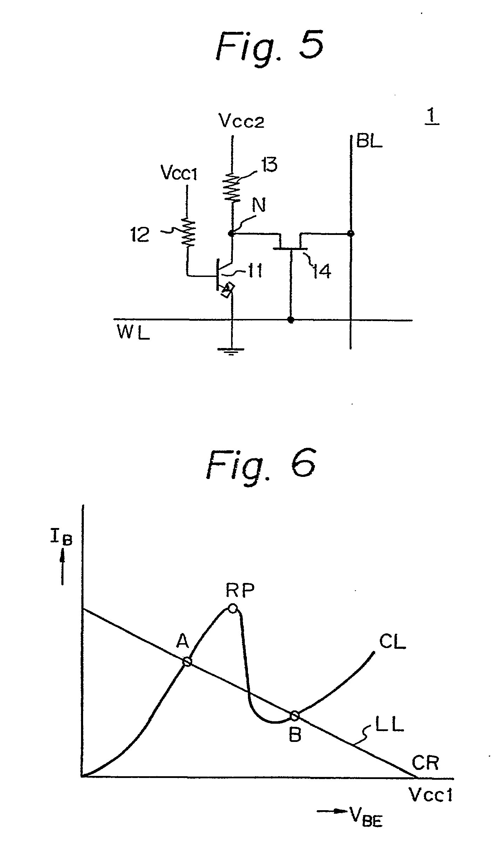

Figure 4 is a graph representing the characteristic of the RHET set forth above. In Fig. 4, the abscissa indicates the base • emitter voltage $V_{BE}$ and the ordinate indicates the mitter current $I_E$. The jagged curve indicates an n-shaped differential negative-resistance characteristic at a first and third quadrants, due to the resonant-tunneling effect. Note, the data in Fig. 4 is given at 77°K with the open collector state.

The present invention uses the above n-differential negative-resistance feature, i.e. n-differential-resistance on the base current.

A first embodiment of the present invention will now be described.

Figure 5 is a circuit diagram of a semiconductor memory cell 1. The memory cell 1 includes a RHET 11, a current source resistor 12, a load resistor 13, and a transfer transistor 14 having a gate connected to a word line WL and a source connected to a bit line BL. A base of the RHET 11 is supplied with a positive voltage $V_{CC1}$ through the resistor 12. The resistor 12 functions as a constant current source provided between the base and the emitter of the RHET 11. A collector of the RHET 11 is supplied with a positive voltage $V_{CC2}$ through the resistor 13. The resistor 13 acts as a load, i.e., a dropping resistor.

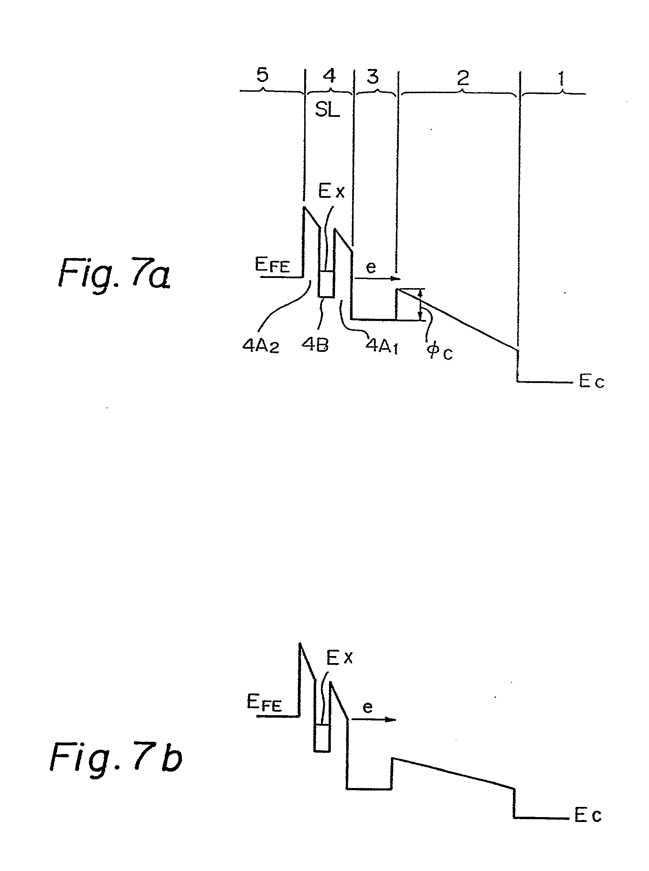

Figure 6 is a view illustrating the characteristics of the memory cell shown in Fig. 5. In Fig. 6, the abscissa represents the base • emitter voltage $V_{BE}$, and the ordinate represents the base current $I_B$. A curce CL indicates the characteristic of the RHET 11. The characteristic curve CL has an n-shaped negative-differential characteristic of the base • emitter voltage $V_{BE}$ and the base current $I_B$. A first summit point RP in the curve CL represents a resonant-tunneling point. A line LL in the figure indicates a load line defined by the voltage $V_{CC1}$ supplied to the base of the RHET 11 and a resistance value of the load resistor 13. The resistance value defines a gradient of the load line LL. The voltage $V_{CC1}$ defines an intersection CR intersecting the load line LL and the abscissa. The load line LL must be determined such that the line LL intersects a first positive slope line of the characteristic curve CL at a point A and a second positive slope line at a point B, to define bistable states of the memory cell at the points A and B. Figures 7a and 7b are views representing energy band diagrams. The graph in Fig. 7a represents an energy state at the point A in Fig. 6. The point A is shifted from the resonant-tunneling point RP, the energy state of which is represented in Fig. 3b. Accordingly, the sub-band energy level $E_X$ at the quantum well layer 4B in Fig. 7a is higher than the energy level $E_{FE}$ at the emitter layer 5. The graph in Fig. 7b corresponds to the graph in Fig. 3c, but the difference between the energy levels at the emitter layer 5 and the collector layer 1 is smaller than that of Fig. 3c. In both states at points A and B, a certain amount of electrons can reach the base layer 3 and the collector layer 1 from the emitter layer 5, and consequently, currents corresponding to the above electrons can flow therein. Here, the resistance value $R_B$ of the current resistor 12 is 1.5

KΩ, the resistance value $R_L$ of the load resistor 12 is 10 KΩ, the voltage $V_{CC1}$ of the constant current source is 1 V, and the voltage $V_{CC2}$ of the load is 1 V.

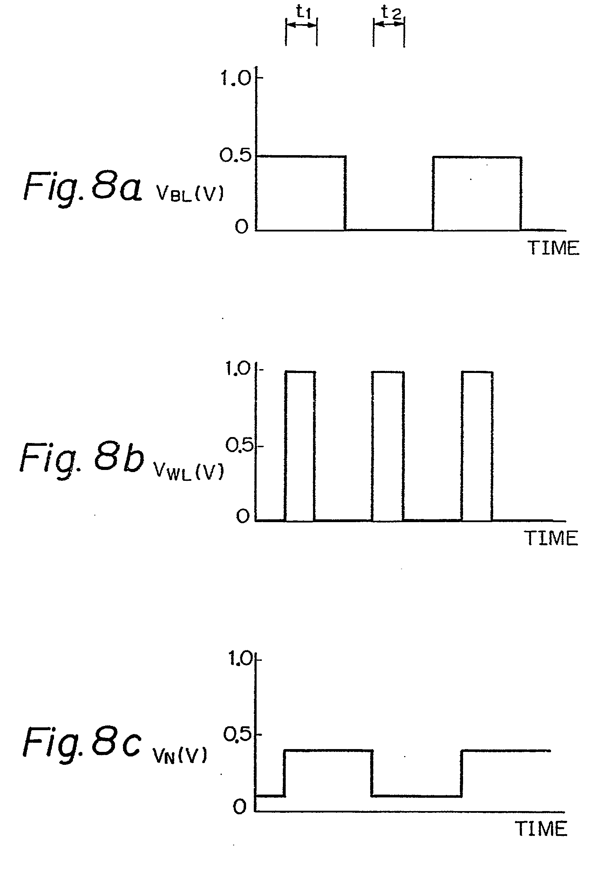

The operation of the semiconductor memory cell in Fig. 5 will be described with reference to Figs. 8a, 8b, and 8c. In the drawings, the abscissas indicate an elapse of time. Figure 8a is a graph of the voltage change $V_{BL}$ of the bit line BL; Fig. 8b is a graph of the voltage change $V_{WL}$ of the word line WL; and, Fig. 8c is a graph of the voltage change $V_N$ at a node N forming a common connection point for the collector of the RHET 11, the load resistor 13, and a collector of the transfer transistor 14.

As set forth above, the resistor 12 functions as the current source, and thus the current source 12 outputs a constant voltage between the base and the emitter of the RHET 11. Conversely, a voltage $V_{CE}$ between the collector and the emitter of the RHET 11 may be varied by supplying a varying voltage to the bit line BL at each time of word line WL selections, as shown in Figs. 8a and 8b.

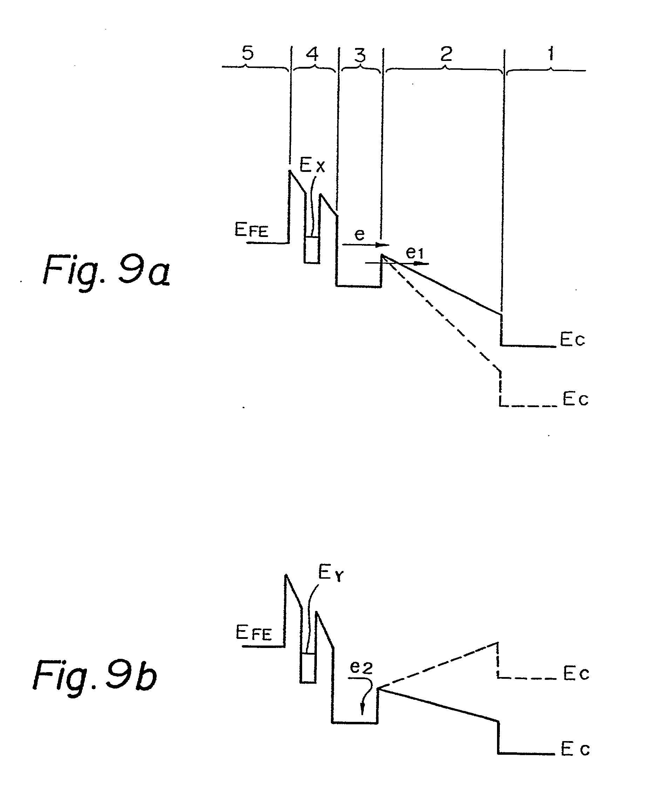

The basic operation of the RHET will now be described with reference to Figs. 9a and 9b. Figure 9a is an energy-band graph of the RHET when the collector • emitter voltage $V_{CE}$ is positively swung in a large amount to widely separate the energy level $E_{FE}$ at the emitter layer 5 and the energy level $E_C$ at the collector layer 1, as shown by a dotted line in the figure. In an energy state as shown by a solid line in the figure, electrons e1 cannot reach the collector layer 1 because of a thick barrier at the potential barrier layer 2. On the other hand, in the energy state as shown by the dotted lline, the barrier at the potential barrier layer 2 has a thickness which will allow the electrons e1 to tunnel therethrough. Accordingly, the electrons e1 reach the collector layer 1, and thus the base current $I_B$ is reduced and, therefore, the base • emitter voltage $V_{BE}$ is raised. Here, the state of the stable point B shown in Fig. 6 may be obtained.

Figure 9b is a graph illustrating an energy-band of the RHET when the collector • emitter voltage $V_{CE}$ is swung between approximately zero volt and a normal value. A solid line in the figure indicates a normal state, and a dotted line indicates a normal state wherein the collector • emitter voltage $V_{CE}$ is approximately zero volt, and thus, when the difference between the emitter layer energy level $E_{FE}$ and the collector layer energy level $E_C$ is small, the potential barrier at the potential barrier layer 2 is raised as shown by the dotted line. Electrons e2 reaching the collector layer 1 in the normal state are reflected at the potential barrier of the potential barrier layer 2 and reach the base layer 3. As a result, the base current $I_B$ is increased, and thus the base • emitter voltage $V_{BE}$ is reduced. Here, the state of the stable point B may be obtained.

By varying the potential at the collector of the RHET 11, the base current $I_B$ of the RHET 11 flows in or out, resulting in a change in the base voltage. Accordingly, the bistable state may be controlled and used for a memory function.

Referring back to Figs. 8a to 8c, during a time $t_1$, the bit line BL is supplied with the voltage $V_{BL}$ of 0.5 V and the word line WL is supplied with the voltage $V_{WL}$ of 1.0 V. The transfer transistor 14 is turned ON by a high level of the voltage $V_{WL}$, and the voltage $V_N$ at the node N is brought approximately 0.4 V. This state corresponds to that of the dotted line in Fig. 9a. During a time $t_2$, the bit line BL is supplied with the voltage $V_{BL}$ of zero volt and the word line WL is supplied with the voltage $V_{WL}$ of 1.0 V, and the transfer transistor 14 is turned ON by the high level of the voltage $V_{WL}$. Since, however, the voltage $V_{BL}$ of the bit line BL is zero volt, the voltage $V_N$ at the node N is approximately 0.1 V. This state corresponds to that shown by the dotted line in Fig. 9b.

Compared with the memory cell in Fig. 5, and the memory in Fig. 1, the principle of the memory storage operation is similar, but it should be noted that, in the read operation, the memory cell in Fig. 5 is supplied with a current through the load resistor 13 connected to the collector of the RHET 11, and is independent of the current source 12 supplying a current for maintaining either the state of point A or the state of point B. Accordingly, the read operation of the memory cell in Fig. 5 can be carried out while stably maintaining a content stored in the memory cell. In addition, compared with the memory cell in Fig. 5 and a conventional static memory cell, the memory cell can be realized by a single storage RHET 11 and a single transfer transistor 14, compared with the conventional static memory cell which requires at least four transistors, i.e. two storage transistors and two transfer transistors. In this regard, the circuit of the memory cell in Fig. 5 is simpler than that of the conventional static memory cell, and this contributes to a higher integration density and a further increase in the speed of operation of the semiconductor memory device, because of the use of a high speed RHET.

In the above description, the RHET 11 has only one sub-band energy level $E_X$. Nevertheless, the RHET 11 may have a plurality of sub-band energy levels, and in this case, a characteristic curve may have a plurality of resonant-point peaks and a plurality of valleys. A plurality of memory cell states can be realized by using a RHET, and accordingly, a multi-level memory cell can be realized.

In addition, the RHET 11 may have a plurality of quantum wells.

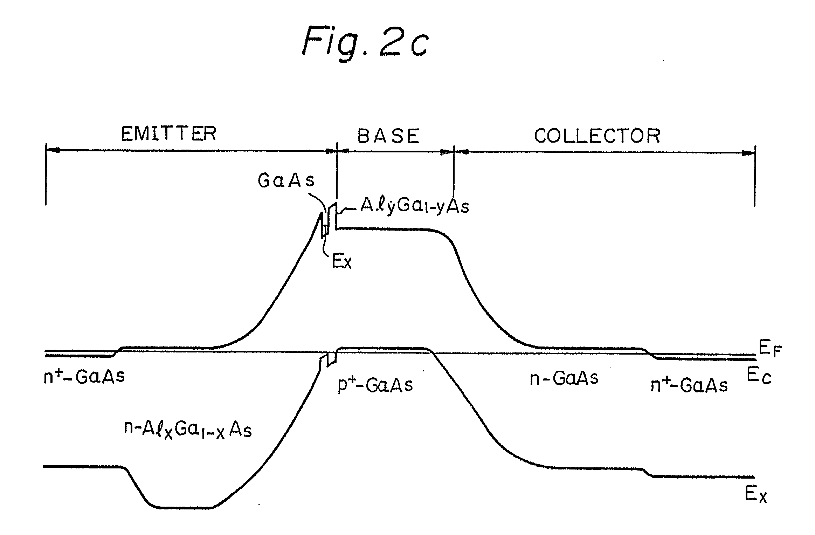

A RHET for use in an embodiment of the present invention may have a P.N. junction barrier instead of the collector barrier formed by the heterojunction as shown in Fig. 2a. Figure 2c is a graph representing an energy band of a resonant-tunneling bipolar transistor (RBT). The RBT consists of an emitter layer of n+-type GaAs, a base layer of p+-type GaAs, and a collector layer of n+-type GaAs. The emitter layer includes a superlattice having at least one quantum well with a sub-band energy Ex. The base layer and the collector layer are PN-joined. The RBT also applies a resonant-tunneling effect and the principle of the operation thereof is similar to that of the RHET, and thus is omitted.

Furthermore, a RHET wherein positive holes are resonant-tunneled may be used instead of the RHET wherein electrons are resonant-tunneled. The resonant-tunneling of holes cause the negative differential resistance in a base current.

The above memory cell includes a latch circuit of the RHET. Accordingly, it should be understood that a latch circuit using a RHET can also be realized easily, in an embodiment of the present invention.

Another embodiment of the present invention will now be described.

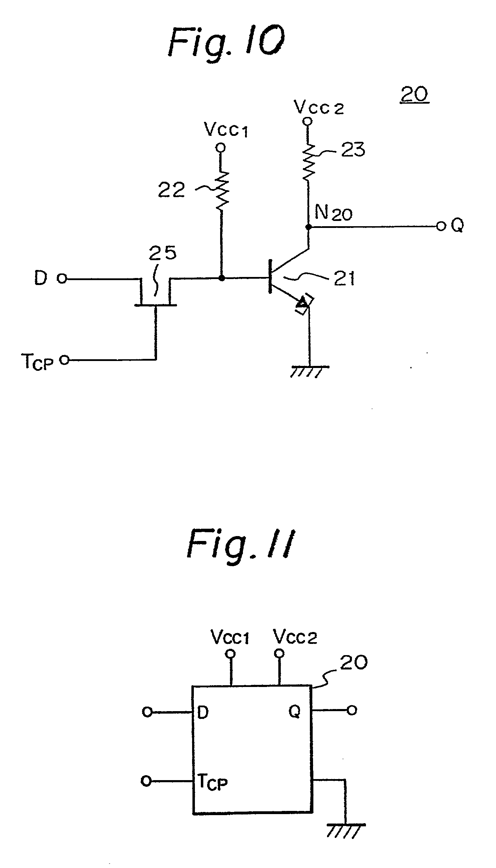

Figure 10 is a circuit diagram of a delay type flip-flop (D–FF) 20 of this embodiment. The D–FF 20 includes a RHET 21, a resistor 22 connected to a base of the RHET 21, a resistor 23 connected to a collector of the RHET 21, and a switching transistor 25. The emitter of the RHET 21 is grounded. The drain of the switching transistor 25 is connected to a data input terminal D, and the gate thereof is connected to a clock pulse input terminal $T_{CP}$. The source of the switching transistor 25, the base of the RHET 21, and the resistor 22 are commonly connected. The resistor 22 supplies a voltage $V_{CC1}$ between the base and the emitter of the RHET 21, and functions as a constant current source, as set forth above. The resistor 23 also supplies a voltage $V_{CC2}$ between the collector and the emitter of the RHET 21, and functions as a negative characteristic resistor. The collector of the RHET 21 is connected to a positive output terminal Q.

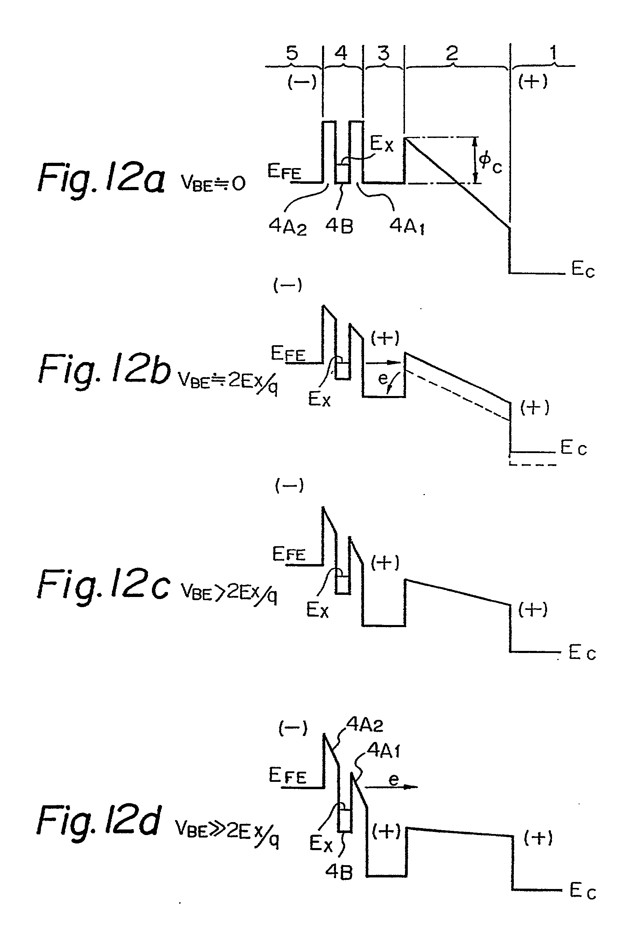

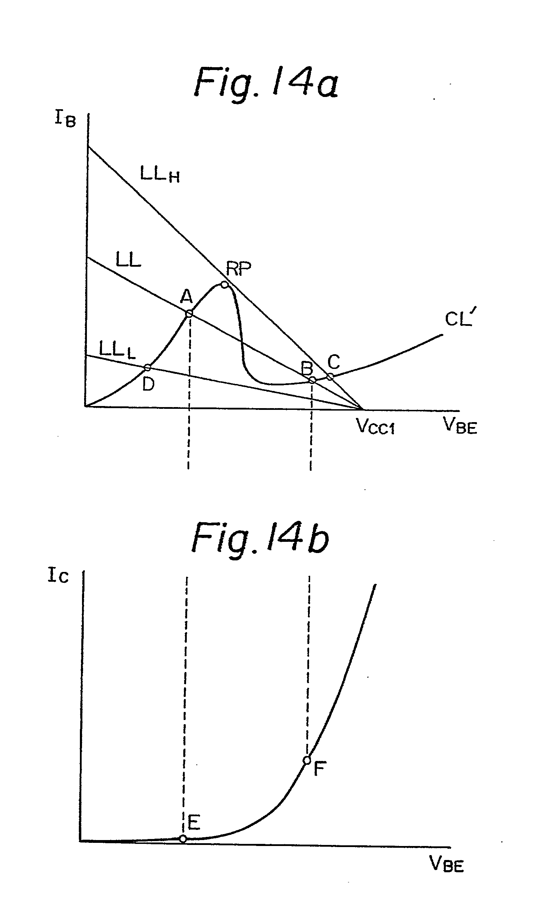

In order to activate the D–FF, the RHET 21 has the n-shaped differential negative-resistance feature as shown in Fig. 14a (described below), and a logic signal "1" or "0" is supplied to the data input terminal D, and a clock pulse given to the clock pulse input terminal $T_{CP}$. After one clock has elapsed, an output signal corresponding to the signal supplied to the data input terminal D appears at a node N20. Therefore, the circuit in Fig. 10 functions as a D–FF. Figure 11 is a block diagram of the D–FF shown in Fig. 10. The D–FF 20 may have at least two stable states, and thus can function as a memory.

The principle and the operation of the D–FF will now be described in more detail with reference to Figs. 12a to 15.

Energy states of the RHET 21 in Fig. 10 will be described with reference to Figs. 12a to 12d. Figure 12a corresponds to Fig. 3a; that ist, the base • emitter voltage $V_{BE}$ is lower than 2 • $E_X/q$, and consequently the sub-band energy level $E_X$ at the quantum well 4B in the superlattice 4 is higher than the energy level $E_{FE}$ at the emitter layer 5. The resonant-tunneling effect does not occur, and thus a current does not pass through the RHET 21. Figure 12b corresponds to Fig. 3b, and in Fig. 12b, a graph partially represented by a dotted line corresponds to the graph shown in Fig. 3b. In this case, the resonant-tunneling effect occurs, and consequently, a collector current flows. On the other hand, a height of a potential barrier at the collector potential barrier layer 2 on a graph represented by a solid line is higher than 2 • $E_X/q$, and thus higher than that of the element shown by the dotted line. As a result,

electrons $\underline{e}$ pass through the superlattice layer 4 and are stopped at the collector barrier layer 2, and the stopped electrons reach the base layer 3. Accordingly, not the collector current but the base current flows. Figure 12c corresponds to Fig. 3c. Here, the energy level $E_{FE}$ at the emitter layer 5 is higher than the sub-band energy level $E_X$, and the resonant-tunneling effect does not exist. Therefore, electrons cannot be injected into the base layer 3 from the emitter layer 5, and thus the base current $I_B$ between the base and the emitter is reduced. Figure 12c is an energy-band graph of the RHET 21 when the base • emitter voltage $V_{BE}$ is too high, i.e., much higher than 2 • $E_X/q$. Here, the energy level $E_{FE}$ at the emitter layer 5 is higher than the subband energy level $E_X$ and is comparable with the barrier height of the barrier layer $4A_1$, and therefore, electrons $\underline{e}$ can reach the base layer 3 by directly tunneling and/or resonant-tunneling effect. The electrons $\underline{e}$ have sufficient energy to pass above the collector potential barrier layer 2, and as a result, reach the collector layer 1 and thus the collector current flows.

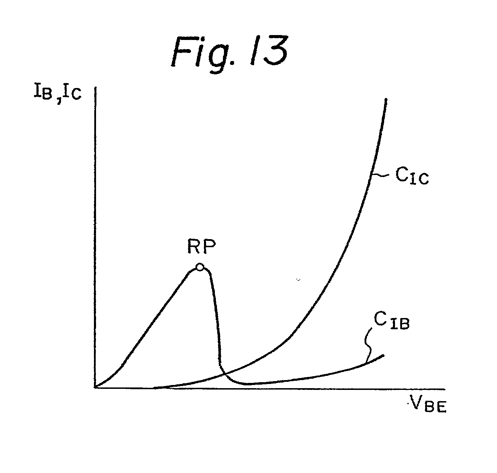

The above characteristics can be seen in Fig. 13. In Fig. 13, the abscissa indicates the base • emitter voltage $V_{BE}$, and the ordinate indicates the base current $I_B$ and the collector current $I_C$. Curves $C_{IB}$ and $C_{IC}$ represent the characteristics of the base current $I_B$ and the base • emitter voltage $V_{BE}$, and the collector current $I_C$ and the base • emitter voltage $V_{BE}$, respectively. In Fig. 13, a differential negative-resistance characteristic having an n-shape appears on the curve $C_{IB}$. This characteristic may be used as a memory function.

Referring back to Fig. 10, the resistor 22 functions as a constant current source between the base and the emitter of the RHET 21, as described above in the first embodiment. Figure 14a is a graph corresponding to Fig. 6. In Fig. 14a, a characteristic curve CL′ corresponds to the characteristic curve CL in Fig. 6; a first straight line LL is a load line when the switching transistor 25 is turned OFF; a second straight line $LL_H$ is an effective load line when the switching transistor 25 is turned ON and the data input terminal D is high; and a third straight line $LL_L$ is an effective load line when the switching transistor 25 is turned ON and the data input terminal D is low. The intersections A, B, C and D are stable points, respectively, and the basic relationship between the load lines LL, $LL_H$ and $LL_L$ and the characteristic curve CL′ is similar to that in Fig. 6. The voltages $V_{CC1}$ and $V_{CC2}$ are respectively 1 V; the resistance value $R_B$ of the constant current source 22 is 1.5 KΩ; and, the resistance value $R_L$ of the load resistor 23 is 10 KΩ.

When the switching transistor 25 is turned OFF, the RHET 21 may have two stable states at the stable points A and B along the load line LL. As the switching transistor 25 is changed from an OFF state to an ON state, and then restored to an OFF state, when the data input terminal D is high, the state of the RHET 21 is transferred to the point B on the load line LL from the point A or B on the load line LL through the point C on the load line LL_H. When the data input terminal D is at a low level, the state of the RHET 21 is transferred to the point A on the load line LL from the point A or B on the load line LL through the point D on the load line LL_L. In this way, by controlling the data input terminal D and the clock pulse input terminal T_CP, the status of the RHET 21 can be changed between the bistable points A and B.

Figure 14b is a graph of the characteristics of the RHET 21, wherein the base • emitter voltage V_BE is shown by the abscissa and the collector current I_C by the ordinate. Points E and F on a curve of the collector current correspond to the bistable points A and B in Fig. 14a. At the state of point B, a large amount of the collector current I_C flows, and as a result, a voltage at the collector of the RHET is low. Conversely, at the state of point A, the collector voltage is high.

From the above, in the write operation, by maintaining a constant supply of a high level voltage to the clock pulse input terminal T_CP and the positive output terminal Q, – high level data, i.e. a logic "1", can be stored in the RHET 21 by supplying a high level voltage to the data input terminal D, or – low level data, i.e. a logic "0", can be also stored therein by supplying a low level voltage, i.e. zero volts, to the data input terminal D. Therefore, in the write operation in this embodiment, the write signal is aplied to the base so as to charge the voltage level V_BE in the RHET. This point is different from the first embodiment in Fig. 5 in which the write signal is applied to the collector.

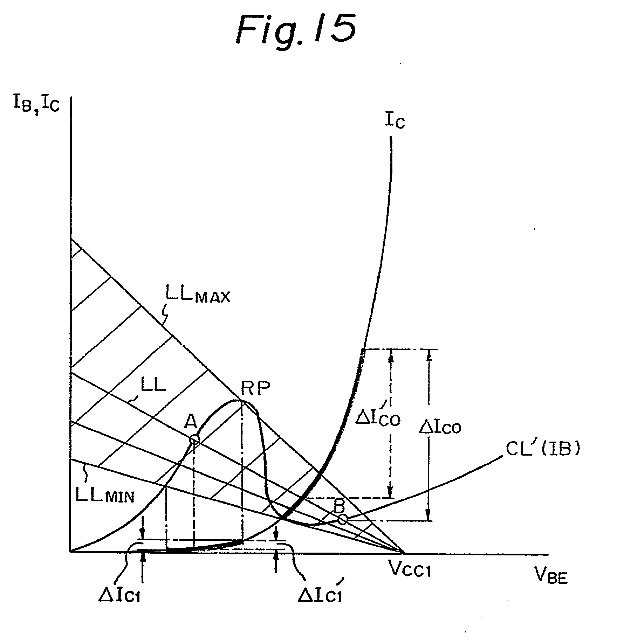

Next, the read operation will be described with reference to Fig. 15. Figure 15 is a view combined with Figs. 14a and 14b.

When the switching transistor 25 is kept in an ON state, the voltage supplied to the data input terminal D changes in a shaded range which does not change the store status in the RHET 21. When the state of the RHET 21 lies at point A, the collector current change ΔI_CI is small, as shown by a bold line. On the other hand, when the state of the RHET 21 lies at point B, the change ΔI_CO of the collector current I_C is large, as shown by another bold line. The above current change will change the voltage V_N20 at the node N_20. A high voltage at the node N_20 indicates a logic "1" stored in the RHET 21, and a low voltage indicates a logic "0" therein.

The D–FF 20 in Fig. 10, acting as a memory cell, can store either high level data or low level data, and the stored data can be read from the D–FF 20 without destruction of the stored data in the RHET 21. This ensures a stable memory operation. Note, the D–FF 20 requires only one storage transistor 21 and one transfer transistor 25 to realize a stable memory cell.

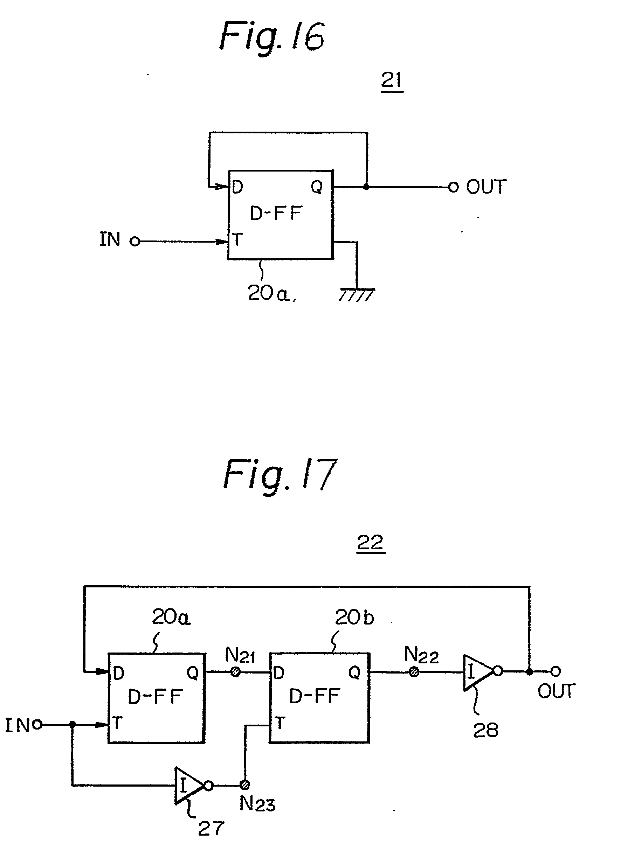

The above read and write operations can be modified, as follows. In the read operation, the voltage V_D of the data input terminal D was changed as shown in Fig. 16b. Instead of this change, the voltage V_D of the data input terminal D is kept at a high level which does not change the state of the data in the RHET 21, and the voltage V_TCP of the clock

pulse input terminal T_CP varies alternately between a high level and a low level. In response to the change of the voltage V_TCP, the switching transistor 25 is turned ON or OFF. When the switching transistor 25 is turned ON, the state of the D–FF 20 lies on a load line LL_MAX in Fig. 15, otherwise it lies on the load line LL. As described above, the change of the voltage at the node N_20 corresponding to the data stored in the RHET 21 can be detected. Compared with the above, the voltage change to be detected may be small on the basis of small collector current chantes ΔI_CO' and ΔI_CI', as shown in dotted lines in Fig. 15.

Figure 16 is a block diagram of a dynamic frequency divider 21 using the D–FF 20 shown in Fig. 11. Here, the data input terminal D and the output terminal Q are connected, and an input signal IN having a frequency f is divided into output signals OUT having the frequency f/2.

The dynamic frequency divider 21 is realized by providing two transistors 21 and 25 as shown in Fig. 10, and is stable in operation. In comparison, a conventional dynamic frequency divider requires at least three transistors. In addition, the dynamic frequency divider 21 can operate at a high speed, since the RHET 21, which can operate stably at a high speed, is used therein.

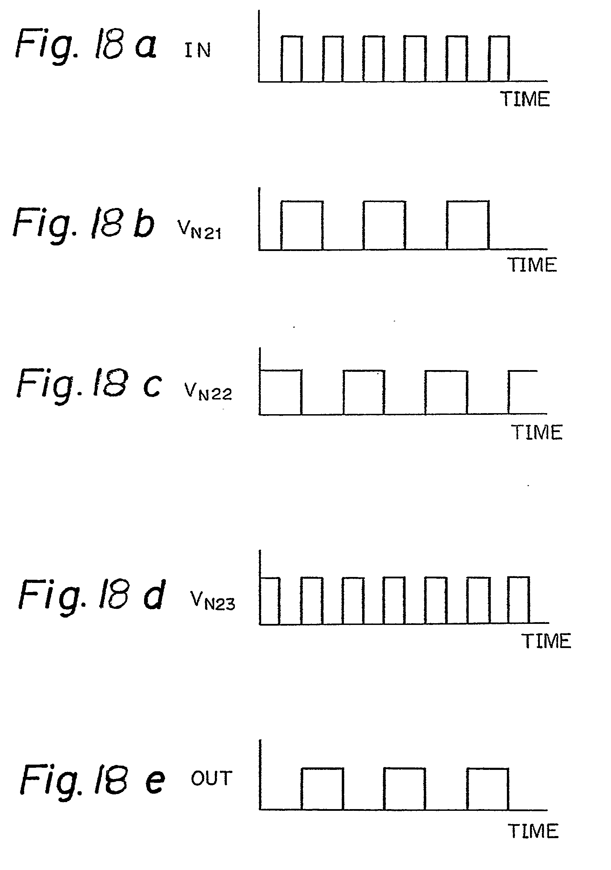

Figure 17 is a block diagram of a static frequency divider 22. The static frequency divider 22 includes two D–FFs 20a and 20b both having the circuit construction shown in Fig. 10, and two inverters 27 and 28. Figures 18a to 18e are timing charts of the static frequency divider 22. Figure 18a is a graph of the input pulse signal IN, Figs. 18b to 18d are graphs of voltage V_N21, V_N22 and V_N23 at nodes N21, N22 and N23, and Fig. 18e is a graph of the output pulse signal OUT. The input pulse signal IN having the frequency f is divided into the output pulse signals OUT having the frequency f/2.

The transistors 14 in Fig. 5 and 25 in Fig. 10 can be replaced by a RHET functioning as a high speed switching transistor.

Many widely different embodiments of the present invention may be constructed without departing from the scope of the present invention. It should be understood that the present invention is not limited to the specific embodiments described in this specification, except as defined in the appended claims.

## Claims

1. Logic circuitry comprising:
a resonant-tunneling transistor (11, 21) including a superlattice (4) containing at least one quantum well layer (4B); and
means (12, 22, V_CC1) operatively connected between a base (7) and an emitter (6) of said transistor and supplying a constant current to said base;
said transistor having a differential negative-resistance characteristic with at least one resonant point (RP) of a resonant-tunneling effect in a relationship between a current (I_B) flowing through said base and a voltage ($V_{BE}$) between said base and emitter, and having at least two stable base current values at both sides of said resonant point, defined by said base • emitter voltage.

2. Circuitry as claimed in claim 1, further comprising load means (13, 23) operatively connected to a collector of said transistor, and output means (14, BL, Q) operatively connected to a commonly connected point (N, N20) of said load means and said collector, for outputting a voltage defined by a change of a current flowing through said collector, which voltage is varied in response to said two stable base current values.

3. Circuitry as claimed in claim 1, further comprising write means (14, BL) operatively connected to a collector of said transistor for changing a voltage at said collector, said write means changing the collector voltage to change a current flowing through said collector and said base emitter voltage being changed in response to the change of said collector voltage, so that said transistor holds one of at least two stable states defined by said stable base current values in response to said change of said collector voltage.

4. A semiconductor memory device comprising a plurality of memory cells arranged between a plurality of bit lines and a plurality of word lines in a matrix fashion,

each memory cell including circuitry as claimed in claim 1, and also including means operatively connected to a collector of said transistor of claim 1 and supplying a current flowing through said collector via a resistor therein, and

switching means operatively connected between a commonly connected point of said collector and said resistor in said current supply means and a corresponding bit line and having a control terminal operatively connected to a corresponding word line,

the said transistor holding one of at least two stable states in response to the change of a voltage at said collector supplied through said switching means in a combination of voltages on said bit line and said word line, and said transistor outputting one of at least two voltages corresponding to said held stable states to said bit line through said switching means energized by a voltage on said word line.

5. Latch circuitry comprising circuitry as claimed in claim 1, and also comprising write means (25) operatively connected to the base of the said transistor of claim 1 and supplying a write voltage to said base; said write means supplying one of at least two write voltages corresponding to said stable base current values to said base to change said base emitter voltage so that the transistor holds one stable state defined by said changed base • emitter voltage.

6. Circuitry as claimed in claim 5, wherein a current is output at a collector of the said transistor of claim 1 which is changeable in response to said state held in said transistor.

7. Circuitry as claimed in claim 6, further comprising means ($V_{CC2}$, 23) connected to said collector and supplying a current to said collector through a resistor (23) therein, wherein a voltage is output at said collector in response to said state held in said transistor.

8. Circuitry as claimed in claim 5, wherein said write means includes switching means (25) having a terminal operatively connected to said base and another terminal receiving a data signal (D) and a control terminal receiving a control signal ($T_{CP}$) energizing same,

said switching means sending said data signal having one amplitude of at least two amplitudes corresponding to said stable base current values to said base in response to said control signal to change said base emitter voltage, so that said transistor holds one stable state defined by said changed base • emitter voltage.

9. Circuitry as claimed in claim 8, further comprising means ($V_{CC2}$, 23) connected to a collector of the said transistor of claim 1 and supplying a current to said collector through a resistor (23) therein, wherein a voltage is output at said collector in response to said state held in said transistor.

10. A dynamic frequency divider comprising circuitry as claimed in claim 1 and also comprising means ($V_{CC2}$, 23) operatively connected to a collector of the said transistor of claim 1 and supplying a current flowing through said collector through a resistor (23) therein; and

signal input means (25) operatively connected to the base of the said transistor of claim 1 and having a data input terminal (D) and a clock input terminal ($T_{CP}$);

said data input terminal and said collector being connected, and an input signal having a pre-determined frequency and an amplitude of at least two amplitudes corresponding to said stable base current values being supplied to said clock input terminal so that an output signal of a half said input frequency is output from said collector.

11. A static frequency divider comprising:

a first delay-type flip-flop (D-FF) (20a), having a clock input terminal (T) receiving an input signal (IN);

a second D-FF (20b) having a data input terminal (D) operatively connected to a positive output terminal (Q) of said first D-FF;

a first inverter (27) provided between said clock input terminal of said first D-FF and a clock input terminal (T) of said second FF; and

a second inverter (28) operatively connecting a positive output terminal (Q) of said second FF and a data input terminal (D) of said first D-FF;

each D-FF including circuitry as claimed in claim 1 and also including means ($V_{CC2}$, 23) operatively connected to a collector of the said transistor of claim 1 and supplying a current flowing through said collector through a resistor (23) therein, and

signal input means (25) operatively connected to the base of the said transistor of claim 1 and having a data input terminal (D) and a clock input terminal ($T_{CP}$),

an input signal having a predetermined frequency and an amplitude of at least two amplitudes corresponding to said stable base current values, being supplied to said clock input terminal of said first D-FF so that an output signal of a half of said input frequency is output from said positive output terminal of said second D-FF.

12. A divider as claimed in claim 10 or 11, wherein said signal input means includes switching means (25) having a terminal operatively connected to said base and another terminal (D) as said data input terminal and a control terminal (T$_{CP}$) as said clock input terminal.

13. Circuitry as claimed in claim 1, 2, 3, 5, 6, 7, 8 or 9, or a device as claimed in claim 4, or a divider as claimed in claim 10, 11, or 12, wherein said resonant-tunneling transistor comprises a resonant-tunneling hot electron transistor.

14. Circuitry as claimed in claim 1, 2, 3, 5, 6, 7, 8 or 9, or a device as claimed in claim 4, or a divider as claimed in claim 10, 11 or 12, wherein said resonant-tunneling transistor comprises a resonant-tunneling bipolar transistor.


## Patentansprüche

1. Logikschaltung mit:
einem Resonanz-Tunneltransistor (11, 21), der ein Supergitter (4) enthält, welches wenigstens eine Quantengrabenschicht (4B) hat; und
Einrichtungen (12, 22, V$_{CC1}$), die wirkungsmäßig zwischen einer Basis (7) und einem Emitter (6) des genannten Transistors verbunden sind und einen Konstantstrom an die genannte Basis liefern;
wobei der genannte Transistor eine differentielle negative Widerstandscharakteristik hat, mit wenigstens einem Resonanzpunkt (RP) von einem Resonanz-Tunneleffekt in einer Relation zwischen einem Strom (I$_B$), der durch die genannte Basis fließt, und einer Spannung (V$_{BE}$) zwischen der genannten Basis und dem Emitter, und der wenigstens zwei stabile Basisstromwerte an beiden Seiten des genannten Resonanzpunktes hat, definiert durch die genannte Basis-Emitterspannung.

2. Schaltung nach Anspruch 1, ferner mit einer Lasteinrichtung (13, 23), die wirkungsmäßig mit einem Kollektor des genannten Transistors verbunden ist, und mit Ausgangseinrichtungen (14, BL, Q), die wirkungsmäßig mit einem gemeinsam verbundenen Punkt (N, N20) der genannten Lasteinrichtung und des genannten Kollektors verbunden sind, um eine Spannung auszugeben, die durch eine Änderung eines Stromes definiert ist, der durch den genannten Kollektor fließt, welche Spannung in Abhängigkeit von den beiden stabilen Basisstromwerten variiert wird.

3. Schaltung nach Anspruch 1, ferner mit einer Schreibeinrichtung (14, BL), die wirkungsmäßig mit einem Kollektor des genannten Transistors verbunden ist, um eine Spannung an dem genannten Kollektor zu ändern, welche Schreibeinrichtung die Kollektorspannung ändert, um einen Strom zu ändern, der durch den genannten Kollektor fließt, und bei der die genannte Basis-Emitter-Spannung in Abhängigkeit von der Änderung der genannten Kollektorspannung geändert wird, so daß der genannte Transistor einen der wenigstens zwei stabilen Zustände, die durch die stabilen Basisstromwerte definiert sind, in Abhängigkeit von der Änderung der genannten Kollektorspannung, hält.

4. Halbleiterspeichervorrichtung mit einer Vielzahl von Speicherzellen, die zwischen einer Vielzahl von Bitleitungen und einer Vielzahl von Wortleitungen matrixartig angeordnet sind,
bei der jede Speicherzelle eine Schaltung nach Anspruch 1 und auch eine Einrichtung enthält, die wirkungsmäßig mit einem Kollektor des genannten Transistors nach Anspruch 1 verbunden und einen Strom liefert, der durch den genannten Kollektor über einen Widerstand darin fließt, und
Schalteinrichtungen, die wirkungsmäßig zwischen einem gemeinsam verbundenen Punkt des genannten Kollektors und des Widerstands in der genannten Stromversorgungseinrichtung und einer entsprechenden Bitleitung verbunden sind und einen Steueranschluß haben, der wirkungsmäßig mit einer entsprechenden Wortleitung verbunden ist,
wobei der genannte Transistor einen der wenigstens zwei stabilen Zustände in Abhängigkeit von der Änderung einer Spannung an dem genannten Kollektor hält, die über die genannte Schalteinrichtung in einer Kombination von Spannungen auf der genannten Bitleitung und der genannten Wortleitung zugeführt wird, und der genannte Transistor eine der wenigstens zwei Spannungen, die den genannten gehaltenen Zuständen entsprechen, über die genannte Schalteinrichtung an die genannte Bitleitung ausgibt, angeregt durch eine Spannung auf der genannten Wortleitung.

5. Verriegelungsschaltung mit einer Schaltung nach Anspruch 1 und mit einer Schreibeinrichtung (25), die wirkungsmäßig mit der Basis des genannten Transistors nach Anspruch 1 verbunden ist und eine Schreibspannung an die genannte Basis liefert; welche genannte Schreibeinrichtung eine von wenigstens zwei Schreibspannungen, die den stabilen Basisstromwerten entsprechen, an die genannte Basis liefert, um die genannte Basisemitterspannung zu ändern, so daß der Transistor einen stabilen Zustand hält, der durch die genannte geänderte Basis-Emitter-Spannung definiert ist.

6. Schaltung nach Anspruch 5, bei der an einem Kollektor des genannten Transistors nach Anspruch 1 ein Strom ausgegeben wird, der in Abhängigkeit von dem genannten Zustand, der in dem Transistor gehalten wird, änderbar ist.

7. Schaltung nach Anspruch 6, ferner mit Einrichtungen (V$_{CC2}$, 23), die mit dem genannten Kollektor verbunden sind und über einen Widerstand (23) darin an den genannten Kollektor einen Strom liefern, wobei in Abhängigkeit von dem genannten Zustand, der in dem genannten Transistor gehalten wird, eine Spannung an dem genannten Kollektor ausgegeben wird.

8. Schaltung nach Anspruch 5, bei der die genannte Schreibeinrichtung Schalteinrichtungen (25) enthält, die einen Anschluß haben, der wirkungsmäßig mit der genannten Basis verbunden ist, und einen anderen Anschluß, der ein Datensignal (D) empfängt, und einen Steueranschluß, der ein Steuersignal (T$_{CP}$) empfängt, das diesen mit Energie versorgt, welche genannte Schalteinrichtung das genannte Datensignal, das eine Amplitude von wenigstens zwei Amplituden hat, die den genannten stabilen Basisstromwerten entsprechen, an die genannte Basis sendet, in Abhängigkeit von dem genannten Steuersignal, um die genannte Basisemitterspannung zu ändern, so daß der genannte Transistor einen stabilen Zustand, der durch die genannte Basis-Emitter-Spannung definiert ist, hält.

9. Schaltung nach Anspruch 8, ferner mit einer Einrichtung ($V_{CC2}$, 23), die mit einem Kollektor des genannten Transistors nach Anspruch 1 verbunden ist und einen Strom an den genannten Kollektor über einen Widerstand (23) darin liefert, bei der eine Spannung in Abhängigkeit von dem genannten Zustand, der in dem genannten Transistor gehalten wird, an dem genannten Kollektor ausgegeben wird.

10. Dynamischer Frequenzteiler mit einer Schaltung nach Anspruch 1 und mit einer Einrichtung ($V_{CC2}$, 23), die wirkungsmäßig mit einem Kollektor des genannten Transistors nach Anspruch 1 verbunden ist und einen Strom liefert, der durch den genannten Kollektor durch einen Widerstand (23) darin fließt; und einer Signaleingabeeinrichtung (25), die wirkungsmäßig mit der Basis des genannten Transistors nach Anspruch 1 verbunden ist und einen Dateneingangsanschluß (D) und einen Takteingangsanschluß ($T_{CP}$) hat; wobei der genannte Dateneingangsanschluß und genannte Kollektor verbunden sind, und ein Eingangssignal, das eine vorbestimmte Frequenz und eine Amplitude von wenigstens zwei Amplituden hat, die den genannten stabilen Basisstromwerten entsprechen, an den genannten Takteingangsanschluß geführt wird, so daß ein Ausgangssignal von einer Hälfte der genannten Eingangsfrequenz von dem genannten Kollektor ausgegeben wird.

11. Statischer Frequenzteiler mit: einem ersten Verzögerungs-Flip-flop (D-FF) (20a), das einen Takteingangsanschluß (T) hat, der ein Eingangssignal (IN) empfängt; einem zweiten D-FF (20b), das einen Dateneingangsanschluß (D) hat, der wirkungsmäßig mit einem positiven Ausgangsanschluß (Q) des genannten ersten D-FF verbunden ist; einem ersten Inverter (27), der zwischen dem genannten Takteingangsanschluß des genannten ersten D-FF und einem Takteingangsanschluß (T) des genannten zweiten FF verbunden ist; und einem zweiten Inverter (28), der wirkungsmäßig mit einem positiven Ausgangsanschluß (Q) des genannten zweiten FF und einem Dateneingangsanschluß (D) des genannten ersten D-FF verbunden ist; wobei jedes D-FF eine Schaltung nach Anspruch 1 und auch eine Einrichtung ($V_{CC2}$, 23) enthält, die wirkungsmäßig mit einem Kollektor des genannten Transistors nach Anspruch 1 verbunden ist und einen Strom liefert, der über einen darin befindlichen Widerstand (23) durch den genannten Kollektor fließt, und eine Signaleingangseinrichtung (25), die wirkungsmäßig mit der Basis des genannten Transistors nach Anspruch 1 verbunden ist und einen Dateneingangsanschluß (D) und einen Takteingangsanschluß ($T_{CP}$) hat, wobei ein Eingangssignal eine vorbestimmte Frequenz und eine Amplitude von wenigstens zwei Amplituden hat, die den genannten stabilen Basisstromwerten entsprechen, dem genannten Takteingangsanschluß des genannten ersten D-FF zugeführt wird, so daß ein Ausgangssignal von der Hälfte der genannten Eingangsfrequenz von dem genannten positiven Ausgangsanschluß des genannten zweiten D-FF ausgegeben wird.

12. Teiler nach Anspruch 10 oder 11, bei dem die genannte Signaleingangseinrichtung eine Schalteinrichtung (25), die einen Anschluß hat, der wirkungsmäßig mit der genannten Basis verbunden ist, und einen anderen Anschluß (D) als dem genannten Datenanschluß und einen Steueranschluß ($T_{CP}$) als den genannten Takteingangsanschluß umfaßt.

13. Schaltung nach Anspruch 1, 2, 3, 5, 6, 7, 8 oder 9, oder Vorrichtung nach Anspruch 4, oder ein Teiler nach Anspruch 10, 11 oder 12, bei denen der genannte Resonanz-Tunneltransistor einen Heißelektronen-Resonanz-Tunneltransistor umfaßt.

14. Schaltung nach Anspruch 1, 2, 3, 5, 6, 7, 8 oder 9, oder Vorrichtung nach Anspruch 4, oder ein Teiler nach Anspruch 10, 11 oder 12, bei denen der genannte Resonanz-Tunneltransistor einen bipolaren Resonanz-Tunnel-Transistor umfaßt.

## Revendications

1. Circuit logique comprenant:
- un transistor à effet tunnel (11, 21) comprenant un super réseau contenant au moins une couche (4b) à puits quantique;
- et des moyens (12, 22, VCC1) connectés en fonctionnement entre une base (7) et un émetteur (6) dudit transistor et fournissant un courant constant à ladite base;
- ledit transistor ayant une caractéristique différentielle de résistance négative avec au moins un point de résonance (RP) d'un effet tunnel en fonction d'une relation entre un courant ($I_B$) circulant entre ladite base et une tension ($V_{BE}$) entre ladite base et l'émetteur et ayant au moins deux valeurs stables de courant de base des deux cotés dudit point de résonance, défini par ladite tension Base • Emetteur.

2. Circuit selon la revendication 1, caractérisé en ce qu'il comporte de plus des moyens de charge (13, 23) connectés en fonctionnement à un collecteur dudit transistor, et des moyens de sortie (14, BL, Q) connectés en fonctionnement à un point de connexion commun (N, N20) desdits moyens de charge et dudit collecteur, pour sortir une tension définie par le changement d'un courant circulant à travers ledit collecteur, laquelle tension varie en fonction desdites deux valeurs stables de courant de base.

3. Circuit selon la revendication 1, caractérisé en ce qu'il comporte de plus des moyens d'écriture (14, BL) connectés en fonctionnement à un collecteur dudit transistor pour faire varier une tension audit collecteur, lesdits moyens d'écriture changeant la tension du collecteur pour changer un courant circulant à travers ledit collecteur, et ladite tension Base • Emetteur étant modifiée en fonction du changement de la tension dudit collecteur, de telle sorte que ledit transistor maintient l'un des deux (ou plus) états stables définis par lesdites valeurs stables de courant de base en réponse audit changement de la tension de collecteur.

4. Dispositif de mémoire à semi-conducteur comprenant une pluralité de cellules mémoires disposées en une pluralité de lignes de bit et une pluralité de lignes de mots dans une répartition matricielle;
- chaque cellule mémoire comportant un circuit selon la revendication 1, et comprenant aussi des moyens connectés en fonctionnement à un collecteur dudit transistor de la revendication 1 et fournissant un courant circulant à travers ledit collecteur via une résistance, et
- des moyens de commutation connectés en fonctionnement entre un point commun de connexion dudit collecteur et de ladite résistance à des moyens d'alimentation en courant et une ligne de bit correspondante, et ayant une borne de contrôle connectée en fonctionnnement à une ligne de mot correspondante,
- ledit transistor maintenant l'un des deux (ou plus) états stables en réponse à la variation d'une tension dudit collecteur fournie à travers lesdits moyens de commutation dans une combinaison de tensions sur ladite ligne de bit et ladite ligne de mot, et ledit transistor sortant l'un des deux (ou plus) tensions correspondantes audit états stables maintenus sur ladite ligne de bit à travers lesdits moyens de commutation activés par une tension sur ladite ligne de mot.

5. Bascule à verrouillage comprenant un circuit logique selon la revendication 1, et comprenant aussi des moyens d'écriture (25) connectés en fonctionnement à la base dudit transistor de la revendication 1, et fournissant une tension d'écriture à ladite base; lesdits moyens d'écriture fournissant une des deux (ou plus) tensions d'écriture correspondant audites valeurs stables du courant de base à ladite base pourchanger ladite tension Base • Emetteur de telle sorte que le transistor maintienne un état stable défini par ladite tension Base • Emetteur après qu'elle ait été changée.

6. Circuit selon la revendication 5, dans lequel un courant est sorti à un collecteur dudit transistor de la revendication 1 qui peut être modifié en fonction dudit état maintenu dans ledit transistor.

7. Circuit selon la revendication 6, comprenant de plus des moyens (VCC2, 23) connecté audit collecteur et fournissant un courant audit collecteur à travers une résistance (23), et dans lequel une tension est sortie audit collecteur en réponse audit état maintenu dudit transistor.

8. Circuit selon la revendication 5, dans lequel lesdits moyens d'écriture comprennent des moyens de commutation (25) ayant une borne connectée en fonctionnement à ladite base et une autre borne recevant un signal de donnée (D) et une borne de contrôle recevant un signal de contrôle (TCP) activant les deux bornes;
- lesdits moyens de commutation envoyant ledit signal de donnée ayant une amplitude d'au moins deux amplitudes correspondantes auxdites valeurs stables du courant de base à ladite base en réponse au signal de contrôle pour changer ladite tension Base • Emetteur, de telle sorte que ledit transistor maintienne un état stable défini par la tension Base • Emetteur une fois qu'elle a été changée.

9. Circuit selon la revendication 8, comprenant de plus des moyens (VCC2, 23) connectés à un collecteur dudit transistor de la revendication 1 et fournissant un courant audit collecteur à travers une résistance (23), circuit dans lequel une tension est fournie en sortie dudit collecteur en réponse audit état maintenu sur ledit transistor.

10. Diviseur de fréquence dynamique comprenant un circuit selon la revendication 1, et comprenant aussi des moyens (VCC2, 23) connectés en fonctionnement à un collecteur dudit transistor de la revendication 1, et fournissant un courant circulant à travers ledit collecteur à travers une résistance (23); et
- des moyens (25) d'entrée de signal connectés en fonctionnement à la base dudit transistor de la revendication 1 et ayant une borne (D) d'entrée de donnée et une borne (TCP) d'une entrée d'horloge;
- ladite borne d'entrée de donnée et ledit collecteur étant reliés, et un signal d'entrée ayant une fréquence prédéterminée et une amplitude, d'au moins deux amplitudes correspondantes audites valeurs stables du courant de base, étant fournie à ladite borne d'entrée d'horloge de telle sorte qu'un signal de sortie d'une fréquence moitié de la fréquence d'entrée est fournie en sortie sur ledit collecteur.

11. Diviseur de fréquence statique comprenant:
- une première bascule flip-flop de type à retard D FF (20a), ayant une borne (T) d'entrée d'horloge recevant un signal d'entrée (IN),
- une seconde bascule D FF (20b) ayant une borne (D) d'entrée de donnée connectée en fonctionnement à une borne de sortie positive (Q) de ladite première bascule D FF;
- un premier inverseur (27) disposé entre ladite borne d'entrée d'horloge de ladite première bascule D FF et une borne d'entrée d'horloge (T) de ladite seconde bascule FF;
- un second inverseur (28) connectant en fonctionnement une borne (Q) de sortie positive de ladite seconde bascule FF et une borne (D) d'entrée de donnée de ladite première bascule D FF;
- chaque bascule D FF comprenant un circuit logique selon la revendication 1 et comprenant aussi des moyens (VCC2, 23) connectés en fonctionnement à un collecteur dudit transistor de la revendication 1 et fournissant un courant circulant à travers ledit collecteur à travers une résistance (23), et
- des moyens (25) d'entrée de signal connectés en fonctionnement à la base dudit transistor de la revendication 1, et ayant une borne (D) d'entrée de donnée et une borne (TCP) d'entrée d'horloge,
- un signal d'entrée, ayant une fréquence prédéterminée et une amplitude d'au moins deux amplitudes correspondantes auxdites valeurs stables de courant de base, étant fourni à ladite borne d'entrée d'horloge de ladite première bascule D FF de telle sorte qu'un signal de sortie d'une fréquence moitié de la fréquence d'entrée est fournie à la borne de sortie positive de ladite seconde bascule D FF.

12. Diviseur selon la revendication 10 ou 11, dans lequel lesdits moyens d'entrée de signal comprennent des moyens de commutation (25) ayant une borne connectée en fonctionnement à ladite base et une autre borne (D) en tant que borne d'entrée de donnée et une borne de contrôle ($T_{CP}$) en tant que borne d'entrée d'horloge.

13. Circuit logique selon l'une des revendications 1, 2, 3, 5, 6, 7, 8 ou 9, ou dispositif selon la revendication 4, ou diviseur selon la revendication 10, 11 ou 12, dans lesquelles ledit transistor à effet tunnel est un transistor à effet tunnel à électrons chauds ou (balistiques).

14. Circuit selon l'une des revendications 1, 2, 3, 5, 6, 7, 8 ou 9, ou dispositif selon la revendication 4, ou diviseur selon la revendication 10, 11 ou 12, dans lesquelles ledit transistor à effet tunnel est un transistor bi-polaire à effet tunnel.

*Fig. 1*

*Fig. 4*

## Fig.2a

## Fig.2b

EP 0 225 698 B1

*Fig. 2c*

EMITTER

BASE

COLLECTOR

GaAs

$A\ell_y Ga_{1-y} As$

$E_x$

$E_F$

$E_c$

$n^+$-GaAs

$p^+$-GaAs

n-GaAs

$n^+$-GaAs

$n^+$-GaAs

$n$-$A\ell_x Ga_{1-x} As$

$E_x$

Fig. 3a $V_{BE} < 2E_X/q$

Fig. 3b $V_{BE} \doteqdot 2E_X/q$

Fig. 3c $V_{BE} > 2E_X/q$

# Fig. 5

# Fig. 6

*Fig. 7a*

*Fig. 7b*

Fig.8a $V_{BL}(V)$

Fig.8b $V_{WL}(V)$

Fig.8c $V_N(V)$

Fig. 9a

Fig. 9b

## Fig. 10

## Fig. 11

EP 0 225 698 B1

Fig. 12a $V_{BE} \fallingdotseq 0$

Fig. 12b $V_{BE} \fallingdotseq 2E_x/q$

Fig. 12c $V_{BE} > 2E_x/q$

Fig. 12d $V_{BE} \gg 2E_x/q$

# Fig. 13

# Fig. 14a

# Fig. 14b

# *Fig. 15*

*Fig. 16*

*Fig. 17*

Fig. 18 a  IN

TIME

Fig. 18 b  $V_{N21}$

TIME

Fig. 18 c  $V_{N22}$

TIME

Fig. 18 d  $V_{N23}$

TIME

Fig. 18 e  OUT

TIME